Europäisches Patentamt

European Patent Office

Office européen des brevets

(11) Veröffentlichungsnummer: **0 351 709**
**A2**

## (12) EUROPÄISCHE PATENTANMELDUNG

(21) Anmeldenummer: **89112775.5**

(22) Anmeldetag: **12.07.89**

(51) Int. Cl.⁴: **H03F 3/72 , H03F 1/02**

(30) Priorität: **21.07.88 DE 3824832**

(43) Veröffentlichungstag der Anmeldung:
**24.01.90 Patentblatt 90/04**

(84) Benannte Vertragsstaaten:
**BE DE FR GB IT NL SE**

(71) Anmelder: **Siemens Aktiengesellschaft**
**Wittelsbacherplatz 2**
**D-8000 München 2(DE)**

(72) Erfinder: **Hosticka, Bedrich J., Prof.**
**Zieglerstrasse 27**
**D-4100 Duisburg(DE)**
Erfinder: **Klinke, Roland, Dipl.-Ing.**
**Tölckestrasse 16**
**D-4600 Dortmund(DE)**
Erfinder: **Pfleiderer, Hans-Jörg, Prof. Dr.**
**Franz-Krinninger-Weg 23**
**D-8011 Zorneding(DE)**

(54) **Differenzverstärker mit extern steuerbarer Leistungsaufnahme.**

(57) Differenzverstärker mit einer "static-bias"-Stufe (T8, T9) zur Einstellung der in den parallelen Schaltungszweigen (L1, T1; L2, T2) fließenden Ruheströme. In Serie zum Ausgangswiderstand (T9) dieser Stufe liegen zwei einander parallel geschaltete Feldeffekttransistoren (T10, T11), die beim Auftreten eines zu verstärkenden Eingangssignals über eine pegelumsetzende Schaltung (PU) so angesteuert werden, daß am Ausgangswiderstand (T9) eine Spannungserhöhung erfolgt, die zu einer Stromanhebung im Differenzverstärker führt. Durch die vom Verstärkereingang (5, 6) her erfolgende, externe Steuerung der Feldeffekttransistoren (T10, T11) sind gute Treibereigenschaften, eine verzerrungsfreie Signalübertragung und eine niedrige Verlustleistung gewährleistet.

**FIG 1**

## Differenzverstärker mit extern steuerbarer Leistungsaufnahme

Die Erfindung bezieht sich auf einen Differenzverstärker nach den gleichlautenden Oberbegriffen der Patentansprüche 1 und 2.

Ein Differenzverstärker dieser Art ist in dem Buch "Design of MOS VLSI Circuits for Telecommunications" von Y. Tsividis und P. Antognetti, erschienen im Verlag Prentice Hall, N. J. (1985) auf den Seiten 129-136, vgl. insbesondere Fig. 5.4, beschrieben. Dort werden zwei der Stromquelle parallel geschaltete, zusätzliche, als steuerbare Stromquellen dienende Feldeffekttransistoren über Stromspiegelschaltungen von den in den parallelen Schaltungszweigen fließenden Strömen derart beeinflußt, daß beim Überschreiten eines festen Spannungswertes durch das einer Gatevorspannung überlagerte Eingangssignal der eine zusätzliche Feldeffekttransistor einen den Ruhestrom der Stromquelle verstärkenden Zusatzstrom liefert, beim Unterschreiten des festen Spannungswertes durch das überlagerte Eingangssignal der andere zusätzliche Feldeffekttransistor. Die Stromspiegelschaltungen sind so ausgebildet, daß der niedrige Ruhestrom durch das signalabhängige Auftreten der Zusatzströme jeweils stark vergrößert wird. Damit erreicht man gute Treibereigenschaften bei gleichzeitiger Reduzierung der Verlustleistung des Differenzverstärkers.

Ein Nachteil dieses bekannten Verstärkers besteht jedoch darin, daß insbesondere bei Zuführung eines Eingangssignals mit steil ansteigenden und abfallenden Flanken, z.B. einer Rechteckspannung, in den aus den parallelen Schaltungszweigen, den Stromspiegelschaltungen und den steuerbaren Stromquellen gebildeten Regelkreisen Instabilitäten auftreten, die sehr oft zu einer Verzerrung des Ausgangssignals führen.

In der älteren deutschen Patentanmeldung P 37 01 791.8 ist ein Differenzverstärker der eingangs genannten Art beschrieben, bei dem zwei der Stromquelle parallel geschaltete, als steuerbare Stromquellen dienende Feldeffekttransistoren vom Schaltungseingang her über eine pegelumsetzende Schaltung so angesteuert werden, daß der niedrige Ruhestrom durch ein vom Eingangssignal abhängiges Auftreten der Zusatzströme jeweils stark vergrößert wird. Gegenüber dem erstgenannten bekannten Differenzverstärker besteht hier der wesentliche Vorteil, daß keine Regelung der zusätzli-chen Stromquellen von der Verstärkerausgangssei-te, sondern eine Steuerung derselben von der Verstärkereingangsseite her erfolgt, und daß somit auch bei zu übertragenden Rechteckspannungen keine wesentlichen Verzerrungen des Ausgangssignals auftreten.

Der Erfindung liegt die Aufgabe zugrunde, einen Differenzverstärker der eingangs genannten Art anzugeben, der durch eine signalabhängige Anhebung seines niedrigen Ruhestroms gute Treibereigenschaften bei niedriger Verlustleistung aufweist und bei dem eine im Vergleich zu den bekannten Differenzverstärkern einfache Erzeugung der zusätzlichen signalabhängigen, sich dem Ruhestrom überlagernden Stromkomponenten erfolgt. Das wird erfindungsgemäß durch eine Ausbildung nach den kennzeichnenden Teilen des Patentanspruchs 1 oder des Patentanspruchs 2 erreicht.

Der mit der Erfindung erzielbare Vorteil besteht insbesondere darin, daß die den Ruhestrom des Differenzverstärkers erzeugende Stromquelle gleichzeitig auch für die Erzeugung der zusätzlichen Stromkomponenten verwendet wird, wobei le-diglich die Ruhestromansteuerung dieser Strom-quelle modifiziert zu werden braucht. Diese Modifizierung erfolgt außerhalb der eigentlichen Schaltung des Differenzverstärkers und ist somit eine externe Schaltungsmaßnahme.

Die Patentansprüche 3 und 4 sind auf bevorzugte Ausgestaltungen und Weiterbildungen der Erfindung gerichtet.

Die Erfindung wird nachfolgend anhand eines in der Zeichnung dargestellten, bevorzugten Aus-führungsbeispiels näher erläutert. Dabei zeigt:

Fig. 1 das Schaltungsprinzip eines Differenzverstärkers nach der Erfindung und

Fig. 2 ein Spannungs-Zeit-Diagramm zur Er-läuterung der Wirkungsweise des Differenzverstär-kers nach Fig. 1.

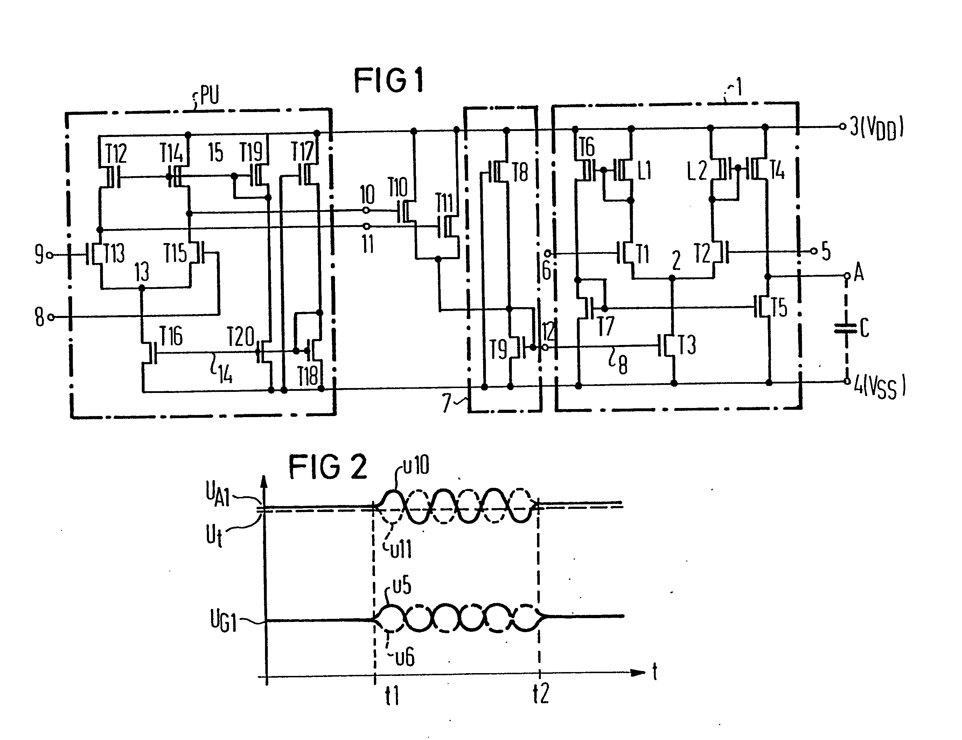

In Fig. 1 ist eine beispielhafte Ausführungsform eines Differenzverstärkers innerhalb des strichpunktierten Blocks 1 dargestellt. Ein Schaltungsknoten 2 ist dabei über zwei parallele Schaltungszweige, von denen der eine die Serienschaltung eines Lastelements L1 und eines n-Kanal-Feldeffekttransistors T1 und der andere die Serienschaltung eines Lastelements L2 und eines n-Kanal-Feldeffekttransistors T2 enthält, mit einem Anschluß 3 verbunden, der mit einer Versorgungsspannung $V_{DD}$ beschaltet ist. Andererseits ist der Schaltungsknoten 2 über einen weiteren Schaltungszweig, der einen als Stromquelle geschalteten n-Kanal-Feldeffekttransistor T3 enthält, mit einem Anschluß 4 verbunden, der auf Bezugspotential $V_{SS}$ liegt. Die Lastelemente L1 und L2 bestehen jeweils aus einem p-Kanal-Feldeffekttransistor, dessen Drainanschluß mit seinem Gateanschluß verbunden ist. Zwischen den Anschlüssen 3 und 4 liegt die Serienschaltung eines p-Kanal-Feldeffekttransistors T4 und eines n-Kanal-Feldeffekttransistors T5, wobei das Gate von T4 mit dem Gate des das Last-element L2 bildenden Feldeffekttransistors verbun-

den ist. Ein weiterer, die Anschlüsse 3 und 4 miteinander verbindender Schaltungszweig enthält die Serienschaltung eines p-Kanal-Feldeffekttransistors T6 und eines n-Kanal-Feldeffekttransistors T7, wobei das Gate von T6 mit dem Gate des das Lastelement L1 bildenden Feldeffekttransistors verbunden ist. Das Gate von T7 ist sowohl mit dem Drainanschluß von T7 als auch mit dem Gate von T5 beschaltet. Der Verbindungspunkt von T4 und T5 ist an den Ausgang A des Differenzverstärkers geführt, während die Gateanschlüsse 5 und 6 der Transistoren T2 und T1 jeweils den positiven und den negativen Verstärkereingang darstellen.

Mit 7 ist eine Schaltungsstufe zur Einstellung der Ruheströme bezeichnet, d.h. der Ströme, die ohne das Auftreten eines zu verstärkenden Eingangssignals an den Eingängen 5 und 6 in den parallelen Schaltungszweigen L1, T1 und L2, T2 fließen. Sie besteht aus der Serienschaltung eines p-Kanal-Feldeffekttransistors T8 und eines n-Kanal-Feldeffekttransistors T9, die zwischen die Anschlüsse 3 und 4 geschaltet ist. Das Gate von T8 liegt an dem mit $V_{SS}$ beschalteten Anschluß 4, so daß in die Serienschaltung T8, T9 ein durch $V_{DD}$ und $V_{SS}$ bestimmter, konstanter Strom fließt. Das Gate von T9 ist mit dem Drainanschluß von T9 verbunden, wobei T9 den ausgangsseitigen Widerstand der Schaltungsstufe 7 darstellt. Der durch T9 fließende, konstante Strom läßt am Drainanschluß von T9 eine konstante Vorspannung abfallen, die über eine die Gates von T9 und T3 verbindende Leitung 8 auch dem Gate von T3 zugeführt wird und diesen Transistor auf einen festen Arbeitspunkt einstellt, in dem er einen Ruhestrom $I_0$ liefert. $I_0$ entspricht der Summe der gleichgroßen Ruheströme $I_0/2$, die die parallelen Schaltungszweige L1, T1 und L2, T2 durchfließen. Die Gates von T1 und T2 sind dabei mit einer Vorspannung $U_{G1}$ beschaltet, die so bemessen ist, daß sich T1 und T2 im leitenden Zustand befinden. Stimmen die strukturellen Auslegungen der Transistoren L2 und T4 überein, so bilden diese einen Stromspiegel, der bewirkt, daß nicht nur L2, sondern auch der Transistor T4 von $I_0/2$ durchflossen wird. In analoger Weise sorgt der aus L1 und T6 bestehende Stromspiegel bei gleicher struktureller Auslegung dieser Transistoren dafür, daß nicht nur L1, sondern auch T6 und damit T7 von $I_0/2$ durchflossen werden. Der aus den gleichstrukturierten Transistoren T7 und T5 bestehende Stromspiegel sorgt schließlich dafür, daß T5 ebenso wie T7 von $I_0/2$ durchflossen wird. Gleichgroße Ströme in den Source-Drain-Strecken von T4 und T5 bedeuten aber, daß über den Ausgang A kein Strom in einen nachgeschalteten Laststromkreis fließt, der durch eine Kapazität C angedeutet wird.

Dieser Ruhestrombetrieb entspricht einem relativ geringen Leistungsverbrauch. Erst beim Auftreten eines zu verstärkenden Eingangssignals an den Verstärkereingängen 5 und 6 wird die Aussteuerung des Transistors T3 so stark erhöht, daß der Differenzverstärker 1 in der Lage ist, dem bei A angeschlossenen, unter Umständen einen großen Widerstand aufweisenden Laststromkreis ein möglichst unverzerrtes und unverzögertes Ausgangssignal zuzuführen. Zu diesem Zweck sind eine pegelumsetzende Schaltung PU und zwei dieser nachgeschaltete p-Kanal-Feldeffekttransistoren T10 und T11 vorgesehen, deren Sourceanschlüsse jeweils mit dem Anschluß 3 verbunden sind, während ihre Drainanschlüsse mit dem Drainanschluß von T9 beschaltet sind. Damit liegt jeder der Transistoren T10 und T11 in Serie zum ausgangsseitigen Widerstand der Schaltungsstufe 7, wobei jede dieser Serienschaltungen die Anschlüsse 3 und 4 miteinander verbindet. Die Eingänge von PU sind mit 8 und 9 bezeichnet, wobei 8 mit dem Eingang 5 des Differenzverstärkers 1 und 9 mit dem Eingang 6 desselben verbunden ist. Der obere Ausgang 10 von PU liegt am Gate von T10, der untere Ausgang 11 am Gate von T11.

Nimmt man an, daß dem Verstärkereingang 5 zum Zeitpunkt t1 ein beispielsweise sinusförmiges Eingangssignal u1 zugeführt wird, daß sich der Vorspannung $U_{G1}$ überlagert, so ergibt sich an 5 ein resultierendes Signal u5, dessen Zeitabhängigkeit in Fig. 2 mit einer ausgezogenen Linie angedeutet ist. Am Eingang 6 liegt dann wegen der inversen Aussteuerung mit u1 ein Signal u6, das in Fig. 2 durch den gestrichelten Verlauf der Spannungskurve gekennzeichnet ist. Durch die Wirkungsweise der pegelumsetzenden Schaltung PU werden an den Ausgängen 10 und 11 Spannungen erhalten, die in Fig. 2 mit u10 und u11 bezeichnet sind. Im einzelnen entspricht u10 einem dem Gate von T10 zugeführten Vorspannungswert $U_{A1}$, dem das in PU verstärkte Eingangssignal u1 überlagert ist, während sich u11 aus dem Vorspannungswert $U_{A1}$ und einem diesem überlagerten, verstärkten und invertierten Eingangssignal u1 zusammensetzt. Liegt $U_{A1}$ geringfügig über der Einsatzspannung $U_t$ der Transistoren T10 und T11, wie in Fig. 2 angedeutet ist, so schaltet jeder $U_t$ unterschreitende Teil der negativen Sinushalbwellen von u11 den Transistor T11 in den leitenden Zustand, so daß ein erster Zusatzstrom von 3 über T11 und T9 nach 4 fließt. Hierdurch erhöht sich die am Anschluß 12 liegende Spannung, die dem Gate von T3 zugeführt wird, so daß auch der von T3 den Zweigen L1, T1 und L2, T2 zugeführte Strom stark erhöht wird. Analog hierzu schaltet jeder $U_t$ unterschreitende Teil der Sinushalbwellen von u10 den Transistor T10 in den leitenden Zustand, so daß ein zweiter Zusatzstrom von 3 über T10 und T9 nach 4 fließt. Dieser bewirkt, daß die am Anschluß 12 liegende Spannung erhöht wird, so daß der von T3 den Zweigen L1, T1 und L2, T2 zugeführte Strom auch in diesen Zeitabschnitten stark erhöht wird. Während des Auftretens des zu verstärkenden Eingangssignals u1, d.h. innerhalb des Zeitintervalls t1 bis t2, wird somit der über t3 kontrollierte Strom durch die parallelen Schaltungszweige L1, T1 und L2, T2 stark angehoben, so daß gute Treibereigenschaften des Differenzverstärkers erreicht werden. Die hierdurch bedingte höhere Leistungsaufnahme des Verstärkers ist aber auf die Zeitspanne beschränkt, in der das Eingangssignal u1 anliegt.

Da die den eingangsseitigen Pegel $U_{G1}$ auf den ausgangsseitigen Pegel $U_{A1}$ umsetzende Schaltung PU von den Verstärkereingängen 5, 6 her angesteuert wird, sind keine Regelkreise wie bei dem eingangs erwähnten, bekannten Differenzverstärker vorhanden, so daß das bei A auftretende Ausgangssignal, das an den Verbindungspunkten der Transistoren L1 und T1 und der Transistoren L2 und T2 abgegriffen und über die Stromspiegel L2, T4 sowie L1, T6 und T7, T5 an den Ausgang A übertragen wird, weitgehend verzerrungsfrei ist. Die Signalübertragung an den Ausgang geht dabei im einzelnen so vor sich, daß sich bei jeder durch die Aussteuerung von T2 und T1 mit dem Eingangssignal u1 bewirkten Größendifferenz der durch L2 und L1 fließenden Ströme eine entsprechende Größendifferenz der Ströme durch T4 und T5 ergibt, die zu einem an A abgreifbaren Ausgangsstrom führt. Beim Differenzverstärker nach der Erfindung spricht das Ausgangssignal sehr schnell auf die Schwankungen des Eingangssignals an, so daß auch Eingangssignale mit steil ansteigenden und abfallenden Flanken, z.B. Rechteckspannungen, weitgehend verzerrungsfrei und mit großer Stromerhöhung an den Ausgang A übertragen werden.

In Fig. 1 ist ein bevorzugtes Ausführungsbeispiel der pegelumsetzenden Schaltung PU innerhalb des linken strichpunktierten Blocks dargestellt. Die als Differenzverstärkerstufe aufgebaute Schaltung enthält im einzelnen zwei zwischen einem Schaltungsknoten 13 und dem mit $V_{DD}$ beschalteten Anschluß 3 angeordnete parallele Stromzweige, von denen der erste einen p-Kanal-Feldeffekttransistor T12 in Serie zu einem n-Kanal-Feldeffekttransistor T13 und der zweite einen p-Kanal-Feldeffekttransistor T14 in Serie zu einem n-Kanal-Feldeffekttransistor T15 aufweist. Der Schaltungsknoten 13 ist über einen Schaltungszweig, der die Source-Drain-Strecke eines n-Kanal-Feldeffekttransistors T16 enthält, mit dem Anschluß 4 verbunden, der mit dem Bezugspotential $V_{SS}$ beschaltet ist. Der Eingang 8 entspricht dem Gateanschluß von T15, der Eingang 9 dem Gateanschluß von T13. Der Ausgang 10 ist mit dem Verbindungspunkt der Transistoren T14 und T15 verbunden, der Ausgang 11 mit dem Verbindungspunkt der Transistoren T12 und T13. Zur Einstellung der Gatespannung von T16 dient ein zwischen den Anschlüssen 3 und 4 liegender Schaltungszweig, der die Serienschaltung eines p-Kanal-Feldeffekttransistors T17 und eines n-Kanal-Feldeffekttransistors T18 enthält. Das Gate von T17 ist mit dem Anschluß 4 verbunden, so daß ein bestimmter Strom durch diese Serienschaltung fließt, der durch das am Gate von T17 liegende Bezugspotential $V_{SS}$ gegeben ist. Das Gate von T18 ist mit dessen Drainanschluß verbunden. Die an diesem abfallende Spannung wird über eine Leitung 14 dem Gate von T16 zugeführt. Ein zweiter zwischen 3 und 4 liegender Schaltungszweig, der die Serienschaltung eines p-Kanal-Feldeffekttransistors T19 und eines n-Kanal-Feldeffekttransistors T20 enthält, dient zur Einstellung der Gatespannungen von T12 und T14. In diesem Schaltungszweig fließt ein Strom, der durch den mit der gleichen Gatespannung wie T16 beaufschlagten Transistor T20 bestimmt wird. T19 ist als Lastelement geschaltet, weil dessen Gateanschluß mit seinem Drainanschluß verbunden ist. Die am Drainanschluß von T19 abfallende Spannung wird den Transistoren T12 und T14 über eine Leitung 15 als Gatespannung zugeführt. Die strukturellen Abmessungen der Transistoren T12 und T14 müssen untereinander gleich sein und sich von den strukturellen Abmessungen des Transistors T16 so weit unterscheiden, daß T12 und T14 im Triodengebiet, d.h. im ansteigenden Teil ihrer $I_D/U_{DS}$-Kennlinie arbeiten, während T16 in der Sättigung betrieben wird. Diese Bedingung läßt sich dadurch erfüllen, daß die Summe der Sättigungsströme von T12 und T14 größer gewählt wird als der Sättigungsstrom von T16. Die strukturellen Abmessungen von T12 und T14 werden weiterhin so gewählt, daß an den Ausgängen 10 und 11 ohne Zuführung eines Eingangssignals u1 das Signal $U_{A1}$ auftritt. Neben dem bisher beschriebenen Fall, daß $U_{A1}$ den Wert der Einsatzspannung $U_t$ von T10 und T11 geringfügig übersteigt, kann der Pegel $U_{A1}$ auch so gewählt werden, daß er dem Wert von $U_t$ genau entspricht oder diesen geringfügig unterschreitet.

Es liegt weiterhin im Rahmen der Erfindung, die Kanaltypen der verwendeten Feldeffekttransistoren jeweils gegeneinander auszutauschen und gleichzeitig die Polaritäten der zugeführten Spannungen durch die entgegengesetzten zu ersetzen. Dabei sind dann auch die Spannungswerte von $U_{A1}$ und $U_{G1}$ miteinander zu vertauschen, was in Fig. 2 bedeutet, daß die Spannungsverläufe u5 und u6 an die Stelle der Spannungsverläufe u10 und u11 treten und umgekehrt. In diesem Fall setzt PU einen höheren Eingangspegel $U_{G1}$, d.h. den Gleichstromanteil des Eingangssignals u1, auf einen niedrigen Ausgangspegel $U_{A1}$ um. $U_{A1}$ liegt dann vorzugsweise geringfügig unter dem Wert der Einsatzspannung $U_t$ der Transistoren T10 und T11, die hierbei dem n-Kanaltyp angehören. Hierbei kann der Wert des Ausgangspegels $U_{A1}$ jedoch auch so gewählt werden, daß er der Einsatzspannung $U_t$ von T10 und T11 genau entspricht oder diese geringfügig übersteigt.

## Ansprüche

1. Differenzverstärker mit zwei parallelen Schaltungszweigen, die jeweils ein Lastelement (L1, L2) und einen Feldeffekttransistor (T1, T2) enthalten, und mit einem als Stromquelle dienenden Feldeffekttransistor (T3), der über einen ersten Schaltungsknoten (2) mit beiden parallelen Schaltungszweigen (L1, T1; L2, T2) verbunden ist und dessen Gateanschluß mit einer Vorspannung beschaltet ist, die in diesen Schaltungszweigen fließende Ruheströme bestimmt, **dadurch gekennzeichnet,** daß eine Schaltungsstufe (7) zur Einstellung der Ruheströme vorgesehen ist, deren ausgangsseitiger Widerstand (T9) mit dem Gateanschluß (12) des als Stromquelle dienenden Feldeffekttransistors (T3) verbunden ist, daß zwei zusätzliche Feldeffekttransistoren (T10, T11) des p-Kanal-Typs jeweils in Serie zu dem ausgangsseitigen Widerstand (T9) angeordnet sind und daß eine pegelumsetzende Schaltung (PU) vorgesehen ist, die eingangsseitig mit den Gateanschlüssen der Feldeffekttransistoren (T1, T2) in den parallelen Schaltungszweigen verbunden ist, die ferner den Gleichstromanteil des Eingangssignals auf einen höheren Ausgangspegel umsetzt, der dem Wert der Einsatzspannung der zusätzlichen Feldeffekttransistoren (T10, T11) etwa entspricht und die ausgangsseitig mit den Gateanschlüssen der beiden zusätzlichen Feldeffekttransistoren (T10, T11) beschaltet ist.

2. Differenzverstärker mit zwei parallelen Schaltungszweigen, die jeweils ein Lastelement (L1, L2) und einen Feldeffekttransistor (T1, T2) enthalten, und mit einem als Stromquelle dienenden Feldeffekttransistor (T3), der über einen ersten Schaltungsknoten (2) mit beiden parallelen Schaltungszweigen (L1, T1; L2, T2) verbunden ist und dessen Gateanschluß mit einer Vorspannung beschaltet ist, die in diesen Schaltungszweigen fließende Ruheströme bestimmt, **dadurch gekennzeichnet,** daß eine Schaltungsstufe (7) zur Einstellung der Ruheströme vorgesehen ist, deren ausgangsseitiger Widerstand (T9) mit dem Gateanschluß (12) des als Stromquelle dienenden Feldeffekttransistors (T3) verbunden ist, daß zwei zusätzliche Feldeffekt transistoren des n-Kanal-Typs jeweils in Serie zu dem ausgangsseitigen Widerstand (T9) angeordnet sind und daß eine pegelumsetzende Schaltung (PU) vorgesehen ist, die eingangsseitig mit den Gateanschlüssen der Feldeffekttransistoren (T1, T2) in den parallelen Schaltungszweigen verbunden ist, die ferner den Gleichstromanteil des Eingangssignals auf einen niedrigeren Ausgangspegel umsetzt, der dem Wert der Einsatzspannung der zusätzlichen Feldeffekttransistoren etwa entspricht und die ausgangsseitig mit den Gateanschlüssen der beiden zusätzlichen Feldeffekttransistoren beschaltet ist.

3. Differenzverstärker nach anspruch 1 oder 2, **dadurch gekennzeichnet,** daß die Schaltungsstufe (7) zur Einstellung der Ruheströme aus der Serienschaltung zweier Feldeffekttransistoren (T8, T9) unterschiedlicher Kanaltypen besteht, daß die Gateelektrode des einen dieser Feldeffekttransistoren (T8) mit einer festen Vorspannung beaufschlagt ist und daß der andere (T9) den ausgangsseitigen Widerstand darstellt, wobei sein Gateanschluß (12) mit seinem Source- oder Drainanschluß sowie mit dem Gateanschluß des als Stromquelle dienenden Feldeffekttransistors (T3) verbunden ist.

4. Differenzverstärker nach einem der vorhergehenden Ansprüche, **dadurch gekennzeichnet,** daß die pegelumsetzende Schaltung (PU) aus einer Differenzverstärkerstufe besteht, die zwei Stromzweige enthält, von denen jeder eine Serienschaltung zweier Feldeffekttransistoren (T12, T13; T14, T15) unterschiedlicher Kanaltypen aufweist, daß ein Stromquellentransistor (T16) des einen Kanaltyps über einen zweiten Schaltungsknoten (13) mit diesen beiden Stromzweigen verbunden ist, daß die Gateanschlüsse der dem Kanaltyp des Stromquellentransistors entsprechenden Feldeffekttransistoren (T13, T15) der Stromzweige die Schaltungseingänge (9, 8) der pegelumsetzenden Schaltung bilden, daß die Verbindungspunkte zwischen den letzteren Feldeffekttransistoren (T13, T15) und den anderen beiden Feldeffekttransistoren (T12, T14) der Stromzweige die Schaltungsausgänge (10, 11) der pegelumsetzenden Schaltung darstellen und daß diese anderen beiden Feldeffekttransistoren (T12, T14) im Triodengebiet arbeiten, während der Stromquellentransistor (T16) im Sättigungsgebiet betrieben wird.

FIG 1

FIG 2

EP 0 351 709 A2